# EUROPEAN PATENT APPLICATION

(11) **EP 2 743 992 A1**
(43) Date of publication of application: **18.06.2014**
(21) Application number: 12821765.0
(22) Date of filing: 10.08.2012
(51) Int. Cl.: H01L 31/04

(54) **METHOD OF MANUFACTURING STACKED-TYPE PHOTOELECTRIC CONVERSION DEVICE**

(30) Priority: 11.08.2011 JP 2011176400
(71) Applicant: Kaneka Corporation, Osaka-shi, Osaka 530-8288 (JP)
(72) Inventor: MATSUDA, Takahiro, Osaka-shi Osaka 530-8288 (JP); OTANI, Tetsuji, Osaka-shi Osaka 530-8288 (JP); GOTO, Masahiro, Osaka-shi Osaka 530-8288 (JP)
(74) Representative: HOFFMANN EITLE
(86) International application number: PCT/JP2012/070448
(87) International publication number: WO 2013/022086

(57) **Abstract**

The present invention relates to a method of manufacturing a stacked-type photoelectric conversion device having a front photoelectric conversion unit (3) and a rear photoelectric conversion unit (4). In a front photoelectric conversion unit, a side contact with the rear photoelectric conversion unit (4) of a reverse-conductivity-type layer (33) is a silicon composite layer, in which a silicon crystalline phase is mixed in with an amorphous alloy containing silicon and oxygen. According to the present invention, after the silicon composite layer of the front photoelectric conversion unit is formed, the crystalline one-conductivity-type layer (41) and the crystalline silicon-based photoelectric conversion layer (42) of the rear photoelectric conversion unit (4) are sequentially formed in the same deposition chamber without being taken out into the ambient air. A power density at the start of deposition of the crystalline silicon-based photoelectric conversion layer (42) is preferably not less than 0.1 times and less than 1 times of a power density during deposition of the silicon composite layer of the front photoelectric conversion unit.

## Description

### TECHNICAL FIELD

The invention relates to a method for manufacturing a stacked-type photoelectric conversion device. Particularly, the present invention relates to a method for manufacturing a stacked-type photoelectric conversion device, which is capable of improving adaptability to a production process and production efficiency, in addition to providing a high-performance photoelectric conversion device.

### BACKGROUND ART

In recent years, for achieving both cost reduction and efficiency enhancement of photoelectric conversion devices, thin-film photoelectric conversion devices have received attention and extensively developed. Generally the thin-film photoelectric conversion device has one or more photoelectric conversion units between a pair of electrodes. Each photoelectric conversion unit has a configuration in which an i-type (intrinsic) photoelectric conversion layer is sandwiched between a p-type layer and an n-type layer. The photoelectric conversion unit is referred to as an amorphous photoelectric conversion unit when a photoelectric conversion layer (i-type layer) constituting a principal part of the photoelectric conversion unit is amorphous, and the photoelectric conversion unit is referred to as a crystalline photoelectric conversion unit when the photoelectric conversion layer is crystalline, irrespective of whether conductivity-type layers (p-type layer and n-type layer) are amorphous or crystalline.

As a method for improving conversion efficiency of a photoelectric conversion device, a stacked-type photoelectric conversion device is known in which two or more photoelectric conversion units are stacked. In the stacked-type photoelectric conversion device, a front photoelectric conversion unit including a photoelectric conversion layer having a relatively wide band gap is arranged on the light incident side, and a rear photoelectric conversion unit having a relatively narrow band gap is arranged behind the front photoelectric conversion unit. Owing to such a configuration, photoelectric conversion over wide wavelength range of incident light can be achieved, so that conversion efficiency of the photoelectric conversion device as a whole can be improved.

In this specification, hereinafter, a photoelectric conversion unit arranged relatively on the light incident side is referred to as a "front photoelectric conversion unit", and a photoelectric conversion unit arranged adjacently to the front photoelectric conversion unit on a side distant from the light incident side is referred to as a "rear photoelectric conversion unit". Unless otherwise specified, the term "front" and "rear" each means being front and rear when viewed from the light incident side.

It has been proposed that in a stacked-type photoelectric conversion device, a conductive intermediate reflection layer having optical transparency and optical reflectivity is provided between a plurality of photoelectric conversion units. In such a configuration, a part of light arriving at an intermediate reflection layer is reflected, so that the light absorption amount in a photoelectric conversion layer of a front photoelectric conversion unit arranged on the light incident side of the intermediate reflection layer is increased, whereby the value of a current generated in the front photoelectric conversion unit can be increased. For example, in a hybrid-type thin-film photoelectric conversion device having an amorphous silicon photoelectric conversion unit as a front photoelectric conversion unit and a crystalline silicon photoelectric conversion unit as a rear photoelectric conversion unit, an intermediate reflection layer arranged between the photoelectric conversion units may increase a photocurrent generated in the amorphous silicon photoelectric conversion unit without increasing the film thickness of an amorphous silicon layer. Further, since the film thickness of the amorphous silicon layer can be decreased, degradation of characteristics of the amorphous silicon photoelectric conversion unit due to photodegradation, which becomes prominent as the film thickness of the amorphous silicon layer is increased, can be suppressed.

Patent Document 1 discloses a stacked-type photoelectric conversion device having as an intermediate reflection layer a silicon composite conductivity-type layer with a silicon crystalline phase mixed in an amorphous alloy of silicon and oxygen. Such a silicon composite conductivity-type layer can be formed by a plasma-enhanced CVD method like a formation of amorphous photoelectric conversion unit and a crystalline photoelectric conversion unit. However, when a rear photoelectric conversion unit is formed in the same deposition apparatus after the silicon composite conductivity-type layer is formed, conversion characteristics may be degraded. Even when high conversion characteristics are exhibited immediately after production of a photoelectric conversion device, conversion characteristics may be degraded if the photoelectric conversion device is exposed to a high-temperature/high-humidity environment.

Patent Document 2 discloses a method in which after a part of an n-type silicon composite layer as an intermediate reflection layer is formed, a substrate is temporarily taken out into the ambient air, and the outermost surface of the silicon composite layer is exposed to the ambient air, followed by forming the rest of the silicon composite layer. According to the method in Patent Document 2, air exposure, evacuation and reheating may improve film quality of a rear photoelectric conversion unit formed on the silicon composite layer, so that conversion characteristics and durability can be improved.

Patent Document 3 discloses that after the whole of a silicon composite layer is formed, a substrate is temporarily taken out into the ambient air, and a one-conductivity-type layer of a rear photoelectric conversion unit is thereafter formed with a low power density, whereby junction of a front photoelectric conversion unit and a rear photoelectric conversion unit can be improved.

### PRIOR ART DOCUMENTS

### PATENT DOCUMENTS

Patent Document 1: Japanese Patent Laid-open Publication No. 2005-45129
Patent Document 2: Japanese Patent Laid-open Publication No. 2005-277303
Patent Document 3: Japanese Patent Laid-open Publication No. 2010-267860

### SUMMARY OF THE INVENTION

### PROBLEMS TO BE SOLVED BY THE INVENTION

When air exposure and reheating are performed after a step of forming a front photoelectric conversion unit and before a step of forming a rear photoelectric conversion unit as disclosed in Patent Documents 2 and 3, initial conversion characteristics and durability of a stacked-type photoelectric conversion device are improved. However, for performing air exposure and reheating, a plurality of CVD apparatuses are necessary , and a step of temporarily carrying a substrate out of a CVD apparatus, carrying the substrate in another CVD apparatus and reheating the substrate is required, so that productivity and production costs should be sacrificed. When deposition is performed in the same CVD apparatus after air exposure, ingress of air elements into the CVD apparatus or film peeling from a CVD electrode due to a decrease in temperature of the inside of the CVD apparatus may occur, leading to degradation of film quality.

Thus, in conventional techniques, it is difficult to achieve both improvement of photoelectric conversion characteristics and durability and improvement of productivity and reduction of production costs. In view of such problems, an object of the present invention is to provide a method for manufacturing a stacked-type photoelectric conversion device having high performance and excellent durability while enhancing adaptability to a production process and improving production efficiency.

### MEANS FOR SOLVING THE PROBLEMS

In view of the situations described above, the inventors have examined deposition conditions for layers forming a stacked-type photoelectric conversion device, and resultantly found that even if air exposure is not performed, a stacked-type photoelectric conversion device having excellent durability is obtained when the concentration of impurities in a crystalline photoelectric conversion layer of a rear photoelectric conversion unit is low. It is also found that as a crystalline photoelectric conversion layer of a rear photoelectric conversion unit is formed with a relatively low power density as compared to a silicon composite layer of a front photoelectric conversion unit, a stacked-type photoelectric conversion device having excellent durability is obtained even though air exposure is not performed.

The present invention relates to a method for manufacturing a stacked-type photoelectric conversion device which includes: a front photoelectric conversion unit having a one-conductivity-type layer, a substantially intrinsic amorphous silicon-based photoelectric conversion layer and a reverse-conductivity-type layer in this order from the light incident side; and a rear photoelectric conversion unit having a crystalline one-conductivity-type layer, a substantially intrinsic crystalline silicon-based photoelectric conversion layer and a reverse-conductivity-type layer in this order from the light incident side. The reverse-conductivity-type layer of the front photoelectric conversion unit on a side in contact with the rear photoelectric conversion unit is a silicon composite layer with a silicon crystalline phase mixed in an amorphous alloy containing silicon and oxygen. The whole of the reverse-conductivity-type layer of the front photoelectric conversion unit may be a silicon composite layer.

The manufacturing method of the present invention includes steps of forming a front photoelectric conversion unit by a plasma-enhanced CVD method, and forming a rear photoelectric conversion unit on the front photoelectric conversion unit by a plasma-enhanced method. In the present invention, after the silicon composite layer is formed, the crystalline one-conductivity-type layer and the crystalline silicon-based photoelectric conversion layer of the rear photoelectric conversion unit are sequentially formed in the same deposition chamber without being taken out into the ambient air.

In the manufacturing method of the present invention, it is preferable that the crystalline silicon-based photoelectric conversion layer of the rear photoelectric conversion unit is formed to have a carbon concentration of 1 × 10¹⁷ atm/cm³ or less, and an oxygen concentration of 2 × 10¹⁸ atm/cm³.

In the manufacturing method of the present invention, a power density at the start of deposition of the crystalline silicon-based photoelectric conversion layer of the rear photoelectric conversion unit is preferably less than 0.1 times and less than 1 times of a power density during deposition of the silicon composite layer of the front photoelectric conversion unit.

In one embodiment of the present invention, a deposition pressure at the start of deposition of the crystalline silicon-based photoelectric conversion layer of the rear photoelectric conversion unit is preferably higher than a deposition pressure during deposition of the silicon composite layer of the front photoelectric conversion unit.

In one embodiment of the present invention, the crystalline silicon-based photoelectric conversion layer of the rear photoelectric conversion unit is formed by depositing an initial deposition part with a power density that is not less than 0.1 times and less than 1 times of the power density during deposition of the silicon composite layer of the front photoelectric conversion unit, followed by forming a bulk part as the rest with a power density higher than that for the initial deposition part. In this case, it is preferred that the power density during deposition of the bulk part of the crystalline silicon-based photoelectric conversion layer of the rear photoelectric conversion unit is not less than the power density during deposition of the silicon composite layer of the front photoelectric conversion unit.

### EFFECTS OF THE INVENTION

According to the production method of the present invention, a stacked-type photoelectric conversion device having excellent initial conversion characteristics and a reduced degradation in conversion characteristics even when exposed to a high-temperature and high-humidity environment is obtained. In the production method of the present invention, it is not necessary to take out a substrate from a deposition apparatus to expose the substrate to the ambient air after a silicon composite layer of a front photoelectric conversion unit is formed, and therefore production efficiency can be improved while adaptability to a production process is enhanced.

### BRIEF DESCRIPTION OF THE DRAWINGS

Fig. 1 is a schematic cross-sectional view showing a stacked-type photoelectric conversion device according to one embodiment of the present invention.
Fig. 2 is a schematic cross-sectional view showing a stacked-type photoelectric conversion device according to one embodiment of the present invention.

### DESCRIPTION OF EMBODIMENTS

Referring to the drawings, preferred embodiments of the present invention will be described below. In the drawings, dimensional relationships, such as thickness and length, are properly altered as needed for clarity and simplicity of the drawings, and do not correspond to actual dimensions.

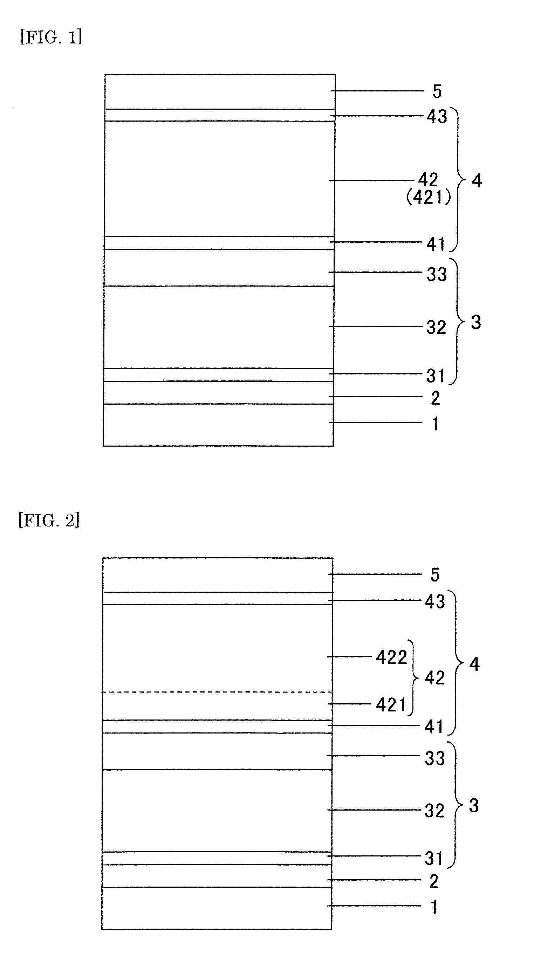

FIG. 1 is a schematic cross-sectional view showing a stacked-type photoelectric conversion device according to one example of the embodiment of the present invention. The stacked-type photoelectric conversion device of FIG. 1 is a double-junction-type stacked-type photoelectric conversion device which includes a transparent electrode layer 2, a front photoelectric conversion unit 3, a rear photoelectric conversion unit 4 and a back electrode layer 5 in this order on a transparent insulating substrate 1.

As the transparent insulating substrate 1, a plate-like member or a sheet-like member made of glass, a transparent resin or the like is used. The transparent electrode 2 is preferably made of a conductive metal oxide, such as SnO₂, ZnO or the like, and is preferably formed by a method such as CVD, sputtering, vapor deposition or the like. The transparent electrode 2 desirably has fine irregularities on its surface so as to have an effect of increasing scattering of incident light.

A plurality of photoelectric conversion units 3 and 4 are arranged rear side of the transparent electrode layer 2. Each of photoelectric conversion unit 3 and 4 is formed of pin junction including one-conductivity-type layer 31 and 41, substantially intrinsic (i-type) photoelectric conversion layer 32 and 42 and reverse-conductivity-type layer 33 and 43, respectively. In a double-junction-type photoelectric conversion device as shown in FIG. 1, a material having a relatively wide band gap is used as the photoelectric conversion layer 32 of the front photoelectric conversion unit 3 arranged on the light incident side. As the photoelectric conversion layer 42 of the rear photoelectric conversion unit 4, a material having a relatively narrow band gap as compared to the photoelectric conversion layer 32 is used. The stacked-type photoelectric conversion device of the present invention includes an amorphous photoelectric conversion unit using an amorphous silicon-based material as the photoelectric conversion layer 32 of the front photoelectric conversion unit 3, and a crystalline photoelectric conversion unit using a crystalline silicon-based material as the photoelectric conversion layer 42 of the rear photoelectric conversion unit 4. The amorphous or crystalline silicon-based material may be an alloy material containing elements such as carbon, oxygen, nitrogen and germanium besides one containing only silicon as a principal element that forms a semiconductor.

One-conductivity-type layers 31 and 41 on the light incident side of the front photoelectric conversion unit 3 and the rear photoelectric conversion unit 4, respectively, are p-type layers (or n-type layers), and accordingly reverse-conductivity-type layers 33 and 43 are n-type layers (p-type layers). Principal constituent materials of the conductivity-type layer are not necessarily required to be identical to photoelectric conversion layers 32 and 42. For example, amorphous silicon carbide may be used for the p-type (or n-type) layer of the amorphous photoelectric conversion unit, and silicon having crystallinity (also referred to as microcrystalline silicon) or a silicon composite material including a crystalline phase in an amorphous alloy may be used for the n-type (p-type) layer.

In each photoelectric conversion unit, the one-conductivity-type layer and the reverse-conductivity-type layer serve to generate a diffusion potential in the photoelectric conversion unit, and the open circuit voltage (Voc), one of characteristics of the thin-film photoelectric conversion device, depends on the magnitude of the diffusion potential. On the other hand, these conductivity-type layers are inactive layers that do not directly contribute to photoelectric conversion, and light absorbed therein hardly contributes to power generation. Therefore, it is preferable that the conductivity-type layers are as thin as possible within the bounds of generating a sufficient diffusion potential, and are transparent.

In the present invention, the silicon composite layer including a silicon crystalline phase in an amorphous alloy of silicon and oxygen is used as an intermediate reflection layer of the stacked-type photoelectric conversion device. For the silicon composite layer to function as an intermediate reflection layer, it should be arranged at any position between the photoelectric conversion layer 32 in the front photoelectric conversion unit 3 and the photoelectric conversion layer 42 in the photoelectric conversion unit 4. In the present invention, the silicon composite layer as an intermediate reflection layer is used in the reverse-conductivity-type layer 33 of the front photoelectric conversion unit 3 on a side in contact with the rear photoelectric conversion unit 4. The whole of the reverse-conductivity-type layer 33 of the front photoelectric conversion unit may be a silicon composite layer.

The reverse-conductivity-type layer 33 may be a multilayer structure of a silicon composite layer and a microcrystalline silicon conductivity-type layer or a silicon oxide conductivity-type layer etc. The reverse-conductivity-type layer 33 may be a multilayer structure in which silicon composite layers having different property values such as those of a refractive index are stacked, or may be a silicon composite with a property value continuously changed in the stacking direction.

The silicon composite layer is formed by a plasma-enhanced CVD method using SiH₄, CO₂, H₂ and PH₃ (or B₂H₆). With respect to the reaction gas feed rate, it is preferable that a reaction gas is fed under so called a microcrystal preparation condition with a high H₂/SiH₄ ratio (hydrogen dilution ratio) and at a CO₂/SiH₄ ratio of 2 or more. Conditions for plasma-enhanced CVD include, for example, a power supply frequency of 10 MHz to 100 MHz, a power density of 50 mW/cm² to 500 mW/cm², a pressure of 50 Pa to 1500 Pa and a substrate temperature of 150°C to 250°C, with using a capacitive-coupling parallel plate electrode. The power density during deposition of a silicon composite layer is more preferably 70 mW/cm² to 300 mW/cm², further preferably 100 mW/cm² to 250 mW/cm². The deposition pressure during deposition of a silicon composite layer is more preferably 300 Pa to 1200 Pa, further preferably 500 Pa to 1100 Pa, especially preferably 700 Pa to 1000 Pa.

In the silicon composite layer, the refractive index to light having a wavelength of 600 nm is preferably 2.5 or less, and the oxygen concentration in the film is preferably 25 atom% or more. There is a relatively high correlation between the refractive index and the oxygen concentration. A function and an effect as an intermediate reflection layer are enhanced as the refractive index decreases. When the CO₂/SiH₄ ratio during deposition of a silicon composite layer is increased, the oxygen concentration tends to monotonously increase while the refractive index decreases. The refractive index of a silicon composite layer can be evaluated by a spectroscopic ellipsometry method. The concentration of oxygen in a silicon composite layer can be measured by, for example, analyzing a composition by SIMS, ESCA, EPMA, Auger electron spectroscopy or the like while changing a detection position (depth) by wet etching, plasma etching, ion sputtering or the like.

In this invention, after the silicon composite layer is formed, the rear photoelectric conversion unit 4 is formed immediately above the silicon composite layer (immediately above the reverse-conductivity-type 33) without taking out a substrate into the ambient air. One example of a specific embodiment of the production method of the present invention will be described below using as an example a double-junction stacked-type photoelectric conversion device in FIG. 1.

First, a transparent electrode layer 2 formed of a transparent conductive oxide (TCO) film is formed on a transparent insulating substrate 1 of glass or the like. The substrate with an electrode is introduced into a plasma-enhanced CVD apparatus, and a one-conductivity-type layer 31, a substantially intrinsic amorphous silicon-based photoelectric conversion layer 32 and a reverse-conductivity-type layer 33 including a silicon composite layer are sequentially formed on the transparent electrode layer 2 by a plasma-enhanced CVD method.

The one-conductivity-type layer 31, the amorphous silicon-based photoelectric conversion layer 32 and the reverse-conductivity-type layer 33 can be formed under appropriate deposition conditions by a plasma-enhanced CVD method. As described above, at least the surface of the reverse-conductivity-type layer 33 on a side in contact with the rear photoelectric conversion unit 4 is a silicon composite layer. The silicon composite layer can be formed under deposition conditions shown above as an example. The film thickness of the silicon composite layer in the reverse-conductivity-type layer 33 is preferably 20 nm to 130 nm. When the film thickness is in the above-mentioned range, a function and an effect as an intermediate reflection layer tend to be enhanced.

After the reverse-conductivity-type layer 33 of the front photoelectric conversion unit 3 is formed, the one-conductivity-type layer 41 of the rear photoelectric conversion unit 4, and the photoelectric conversion layer 42 are formed in the same deposition chamber without taking out a substrate into the ambient air. Since the rear photoelectric conversion unit is formed without temporarily taking out the substrate into the ambient air as described above, production efficiency of the stacked-type photoelectric conversion device is enhanced. In the present invention, it is preferable that after the reverse-conductivity-type layer 33 is formed, the one-conductivity-type layer 41 of the rear photoelectric conversion unit 4, the photoelectric conversion layer 42 and the reverse-conductivity-type layer 43 are formed in the same deposition chamber without taking out the substrate into the ambient air.

The one-conductivity-type layer 41 of the rear photoelectric conversion unit 4 is a silicon-based semiconductor layer. The crystalline one-conductivity-type layer 41 is formed by, for example, a plasma-enhanced CVD method using SiH₄, H₂ and B₂H₆ (or PH₃). With respect to the reaction gas feed rate, it is preferable that a reaction gas is fed under so called a microcrystal preparation condition with a high H₂/SiH₄ ratio (hydrogen dilution ratio). Conditions for plasma-enhanced CVD include, for example, a power supply frequency of 10 MHz to 100 MHz, a power density of 50 mW/cm² to 500 mW/cm², a pressure of 50 Pa to 1500 Pa and a substrate temperature of 150°C to 250°C. In the present invention, a silicon composite layer may be formed as the one-conductivity-type layer 41, so that both the reverse-conductivity-type layer 33 of the front photoelectric conversion unit and the one-conductivity-type layer 41 of the rear photoelectric conversion unit can be made to act as an intermediate reflection layer.

The crystalline silicon-based photoelectric conversion layer 42 made of a substantially intrinsic crystalline silicon-based material is formed on the one-conductivity-type layer 41. In the present invention, a power density of plasma-enhanced CVD at the initial stage of deposition of the crystalline silicon-based photoelectric conversion layer is preferably not less than 0.1 times and less than 1.0 times of a power density during deposition of the silicon composite layer.

By ensuring that the power density at the initial stage of deposition of the crystalline silicon-based photoelectric conversion layer is lower than the power density during deposition of the silicon composite layer, ingress of impurity atoms in the silicon composite layer into the crystalline silicon-based silicon composite layer 42 is suppressed even when air exposure is not performed after deposition of the silicon composite layer. Thus, according to the production method of the present invention, a stacked-type photoelectric conversion device having excellent durability with degradation of photoelectric conversion characteristics suppressed even when exposed to a high-temperature and high-humidity environment is obtained. When a power density at the initial stage of deposition of the crystalline silicon-based photoelectric conversion layer is not less than 0.1 times of a pressure during deposition of the silicon composite layer, crystallization easily proceeds and an excessive reduction in productivity can be avoided.

A power density at the initial stage of deposition of the crystalline silicon-based photoelectric conversion layer 42 is more preferably 0.4 to 0.9 times, further preferably 0.45 to 0.85 times, especially preferably 0.5 to 0.8 times of a power density during deposition of the silicon composite layer.

In the present invention, the power density at the initial stage of deposition of the crystalline silicon-based photoelectric conversion layer 42, i.e., at the start of deposition, should be in the aforementioned range, and the power density for a bulk part of the crystalline silicon-based photoelectric conversion layer 42 may exceed the above-described range. For example, as shown in FIG. 2, an initial stage deposition part 421 of the photoelectric conversion layer 42 is formed with a relatively low power density, and the subsequent bulk part 422 is formed with an increased power density, so that the deposition rate of the photoelectric conversion layer 42 can be increased.

When the power density is changed between the initial stage deposition part 421 and the bulk part 422 of the crystalline silicon-based photoelectric conversion layer 42, preferably a part having a film thickness of 100 nm or more at the initial stage of deposition is formed with a relatively low power density as described above, and more preferably a part of 250 nm or more, further preferably a part of 400 nm or more is formed with a relatively low power density for inhibiting degradation of durability due to diffusion of impurities.

Generally, the silicon composite layer as an intermediate reflection layer is formed with a low power density as precise control for uniformity of the film thickness and the refractive index in the surface is important for reflecting light to the front photoelectric conversion unit. Deposition with a low power density enhances uniformity of film quality, but decreases the deposition rate, leading to a reduction in productivity. However, the film thickness of the intermediate reflection layer is at most about 100 nm, and therefore generally film quality is prioritized over the deposition rate.

On the other hand, the film thickness of the crystalline silicon-based photoelectric conversion layer is required to be about 1 µm to 5 µm for matching the current values of the amorphous photoelectric conversion unit as a front photoelectric conversion unit and the crystalline photoelectric conversion unit as a rear photoelectric conversion unit in the stacked-type photoelectric conversion device. Since this film thickness is about 10 to 100 times of the film thickness of the silicon composite layer, the deposition rate of the crystalline photoelectric conversion layer is a bottleneck in improvement of productivity of the stacked-type photoelectric conversion device. Therefore, the crystalline photoelectric conversion layer is commonly formed at a high speed with a high power density.

On the other hand, the present invention, in which the crystalline silicon-based photoelectric conversion layer is formed at a low speed with a power density lower than that for the silicon composite layer, has been devised based on the novel finding that by employing deposition conditions in a direction reverse to conventional techniques, diffusion of impurity atoms is suppressed to improve durability of the stacked-type photoelectric conversion device.

In the production method of the present invention, the deposition rate may become relatively low at the start of deposition of the crystalline silicon-based photoelectric conversion layer, but a step of exposing to the ambient air a substrate provided with a silicon composite layer is not required, and therefore productivity is rather improved as compared to conventional techniques. Further, by forming the bulk part 422 of the crystalline silicon-based photoelectric conversion layer 42 with a relatively high power density, productivity can be further improved.

When the bulk part 422 of the crystalline silicon-based photoelectric conversion layer 42 is formed with a relatively high power density, it is preferable that the bulk part is formed with a power density not less than that during deposition of the silicon composite layer of the front photoelectric conversion unit 3. More specifically, a deposition power density for the bulk part 422 of the crystalline silicon-based photoelectric conversion layer 42 is preferably 1 to 2 times, more preferably 1.1 to 1.5 times of a power density during deposition of the silicon composite layer of the front photoelectric conversion unit 3.

In the present invention, the ratio with a deposition power density during deposition of the silicon composite layer is more important than the absolute value of a deposition power density for the crystalline silicon-based photoelectric conversion layer for suppressing diffusion of impurity atoms. Therefore, durability can also be improved by increasing the deposition power density during deposition of the silicon composite layer without changing the deposition power density for forming the crystalline photoelectric conversion layer.

The reason why the effect of preventing diffusion of impurities depends on a ratio of the power density, but one factor may be that since deposition is performed with a relatively low power density, plasma etching of the previously formed silicon composite layer or plasma etching of substances deposited on the wall surface of the apparatus during deposition of the silicon composite layer is suppressed. That is, it is considered that since plasma etching of the silicon composite layer (or its substances deposited on the wall surface of the apparatus) is suppressed, carbon, oxygen and conductivity-type determining impurities (phosphorus, boron etc.), *i.e.,* constituent elements of the silicon composite layer are hard to be entrapped in the crystalline photoelectric conversion layer as impurities, so that film quality of the crystalline photoelectric conversion layer is improved.

In the stacked-type photoelectric conversion device of the present invention, the impurity concentration of the crystalline photoelectric conversion layer 42 is preferably low. Specifically, the carbon concentration is preferably 2 × 10¹⁷ atm/cm³ or less, more preferably 1 × 10¹⁷ atm/cm³ or less. The oxygen concentration is preferably 3 × 10¹⁸ atm/cm³ or less, more preferably 2 × 10¹⁸ atm/cm³ or less. The phosphorus concentration and the boron concentration are preferably 2 × 10¹⁷ atm/cm³ or less, more preferably 1 × 10¹⁷ atm/cm³ or less. The impurity concentration can be quantitatively determined by secondary ion mass spectroscopy (SIMS).

Further, in a preferred embodiment of the present invention, the deposition pressure at the start of deposition of the crystalline silicon-based photoelectric conversion layer 42 of the rear photoelectric conversion unit 4 is set to a pressure not less than the deposition pressure during deposition of the silicon composite layer of the reverse-conductivity-type layer 33 of the front photoelectric conversion unit 3. A deposition pressure at the start of deposition of the crystalline silicon-based photoelectric conversion layer 42 is more preferably 1 to 5 times, further preferably 1.1 to 2 times of a deposition pressure during deposition of the silicon composite layer. When the deposition pressure is increased, ingress of impurity atoms in the silicon composite layer into the crystalline silicon-based photoelectric conversion layer 42 tends to be further suppressed. On the other hand, in the case where the power density is the same, the deposition rate tend to decrease when the deposition pressure is increased. Therefore, in the present invention, a ratio of a deposition pressure and a power density (power density/deposition pressure, unit: mW/cm² · Pa) at the start of deposition of the crystalline silicon-based photoelectric conversion layer 42 is preferably 0.1 to 1 times, further preferably 0.4 to 0.9 times of a ratio of a deposition pressure and a power density during deposition of the silicon composite layer.

Further, in the present invention, a power density, at the time of forming the crystalline one-conductivity-type layer 41 of the rear photoelectric conversion unit 4 is preferably not less than 0.1 times and less than 1 times of a power density during deposition of the silicon composite layer. A power density during deposition of the one-conductivity-type layer 41 is more preferably 0.1 to 0.9 times, further preferably 0.4 to 0.8 times of a power density during deposition of the silicon composite layer. The deposition pressure at the time of forming the crystalline one-conductivity-type layer 41 of the rear photoelectric conversion unit 4 is preferably not less than the deposition pressure during deposition of the silicon composite layer. A deposition pressure during deposition of the one-conductivity-type layer 41 is more preferably 1 to 5 times, further preferably 1.1 to 2 times of a deposition pressure during deposition of the silicon composite layer.

When the crystalline one-conductivity-type layer 41 of the rear photoelectric conversion unit 4 is formed with a relatively low power density and high pressure, junction between the silicon composite layer of the reverse-conductivity-type layer 33 and the crystalline one-conductivity-type layer 41 of the rear photoelectric conversion unit 4 can be improved, and diffusion of impurities into the crystalline photoelectric conversion layer 42 tends to be suppressed. From the same point of view, a ratio of a deposition pressure and a power density (power density/deposition pressure, unit: mW/cm² ·Pa) during deposition of the crystalline one-conductivity-type layer 41 is preferably 0.1 to 1 times, further preferably 0.4 to 0.9 times of a ratio of a deposition pressure and a power density during deposition of the silicon composite layer.

The reverse-conductivity-type layer 43 is formed on the crystalline photoelectric conversion layer 42 under appropriate deposition conditions by a plasma-enhanced CVD method. For the reverse-conductivity-type layer, crystalline silicon, or a crystalline material such as silicon composite with a silicon crystalline phase mixed in an amorphous alloy such as SiO, SiC or SiN is suitable. The reverse-conductivity-type layer 43 may be one formed by stacking a plurality of conductivity-type layers.

A back electrode layer 5 is formed on the rear photoelectric conversion unit 4. As the back electrode layer 5, it is preferable to form a metal layer formed of Al, Ag, Au, Cu, Pt, Cr or the like by a sputtering method, a vapor deposition method or the like. Preferably a layer formed of a conductive oxide such as ITO, SnO₂ or ZnO is formed between the photoelectric conversion unit and the metal layer for enhancing the optical confinement effect. The back electrode layer may be formed as one composed of a single layer of a conductive oxide, which does not include a metal layer, by appropriately adjusting the conductive oxide layer to optimize reflection characteristics.

The present invention has been described above using as an example a double-junction stacked-type photoelectric conversion device having the amorphous photoelectric conversion unit 3 and the crystalline photoelectric conversion unit 4, but the present invention may also be applied to a multi-junction stacked-type photoelectric conversion device having three or more photoelectric conversion units. For example, in a triple-junction stacked-type photoelectric conversion device with a first photoelectric conversion unit, a second photoelectric conversion unit and a third photoelectric conversion unit arranged in this order from the light incident side, the first photoelectric conversion unit and the second photoelectric conversion unit may be set as a front photoelectric conversion unit and a rear photoelectric conversion unit, respectively. In this case a silicon composite conductivity-type layer is provided in boundary between these photoelectric conversion units. Alternatively, the second photoelectric conversion unit and the third photoelectric conversion unit may be set as a front photoelectric conversion unit and a rear photoelectric conversion unit, respectively, and a silicon composite conductivity-type layer is provided in boundary therebetween. In a triple-junction-type stacked-type photoelectric conversion device, a silicon composite layer may be provided in each of the boundaries between the first photoelectric conversion unit and the second photoelectric conversion unit and between the second photoelectric conversion unit and the third photoelectric conversion unit.

In the case of a triple-junction stacked-type photoelectric conversion device, for example, an amorphous silicon photoelectric conversion unit is applied to the first photoelectric conversion unit, an amorphous silicon germanium or crystalline silicon-based photoelectric conversion unit is applied to the second photoelectric conversion unit, and an amorphous silicon germanium or crystalline silicon-based photoelectric conversion unit is applied to the third photoelectric conversion unit. The combination of photoelectric conversion units in the multi-junction-type stacked photoelectric conversion device is not limited to those described above, and various kinds of other combinations may be employed.

### EXAMPLES

Hereinafter, by way of Examples, the present invention will be described more in detail by comparison with Comparative Examples from conventional techniques while showing a double-junction-type stacked-type photoelectric conversion device in which an amorphous silicon photoelectric conversion unit and a crystalline silicon photoelectric conversion unit are stacked. The present invention is not limited to Examples below as long as the spirit thereof is not exceeded.

### (Example 1)

In Example 1, a stacked-type photoelectric conversion device schematically shown in FIG. 1 was prepared. First, a transparent electrode layer 2 having SnO₂ as a principal component was formed on a transparent glass substrate 1. The substrate with a transparent electrode layer was introduced into a first plasma-enhanced CVD apparatus, the temperature was elevated, and as an amorphous photoelectric conversion unit 3, a p-type amorphous silicon carbide layer 31, an amorphous silicon photoelectric conversion layer 32 and an n-type silicon composite layer 33 were formed in thicknesses of 15 nm, 300 nm and 50 nm, respectively.

The n-type silicon composite layer 33 was formed under conditions including a gas flow ratio of SiH₄/CO₂/PH₃/H₂ = 1/2.5/0.025/350, a deposition pressure of 990 Pa, a power supply frequency of 13.56 MHz, a power density of 163.7 mW/cm² and a substrate temperature of 180°C. The obtained n-type silicon composite layer 33 had a refractive index of 2.0 to light having a wavelength of 600 nm.

After deposition of the n-type silicon composite layer 33, the first plasma-enhanced CVD apparatus was evacuated. Thereafter, a p-type microcrystalline silicon layer (one-conductivity-type layer) 41 of a crystalline photoelectric conversion unit 4 was formed in a thickness of 15 nm without taking out the substrate into the ambient air. The p-type microcrystalline silicon layer 41 was formed under conditions including a gas flow ratio of SiH₄/B₂H₆/H₂ = 1/0.0028/222, a deposition pressure of 990 Pa, a power supply frequency of 13.56 MHz, a power density of 148.8 mW/cm² and a substrate temperature of 170°C.

Thereafter, a crystalline silicon photoelectric conversion layer 42 was formed in a thickness of 2.5 µm. The crystalline silicon photoelectric conversion layer 42 was formed under conditions including a gas flow ratio of SiH₄/H₂ = 1/115, a deposition pressure of 990 Pa, a power supply frequency of 13.56 MHz, a power density of 148.8 mW/cm² and a substrate temperature of 160°C.

Thereafter, an n-type microcrystalline silicon layer 43 was formed in a thickness of 15 nm as a reverse-conductivity-type layer. The n-type microcrystalline silicon layer 43 was formed under conditions including a gas flow ratio of SiH₄/PH₃/H₂ = 1/0.015/200, a deposition pressure of 990 Pa, a power supply frequency of 13.56 MHz, a power density of 74.4 mW/cm² and a substrate temperature of 180°C.

On the crystalline photoelectric conversion unit thus formed, an Al-doped ZnO layer having a thickness of 90 nm and a Ag layer having a thickness of 200 nm were sequentially formed as a back electrode layer 5 using a sputtering method.

By passing through the steps described above, a double-junction-type stacked-type photoelectric conversion device, in which an amorphous silicon photoelectric conversion unit and a crystalline silicon photoelectric conversion unit were stacked, was prepared. For completion of manufacturing a photoelectric conversion device element, steps of separating an element, forming an takeout electrode portion, etc., were carried out, in addition to the above-described steps, in accordance with a usual method. Details of these steps are omitted here.

Light of AM 1.5 was applied in a light amount of 100 mW/cm² using a solar simulator under an environment of 25°C to measure photoelectric conversion characteristics of the stacked-type photoelectric conversion device of Example 1. The stacked-type photoelectric conversion device had an open circuit voltage (Voc) of 1.38 V, a short circuit current density (Isc) of 11.13 mA/cm², a fill factor (F.F.) of 0.730 and a conversion efficiency (Eff.) of 11.18 %.

### (Example 2)

In Example 2, the gas flow ratio was changed to SiH₄/CO₂/PH₃/H₂ = 1/2.0/0.025/350, and the deposition pressure was changed to 750 Pa in deposition of the n-type silicon composite layer 33. Otherwise in the same manner as in Example 1, a double-junction-type stacked-type photoelectric conversion device was prepared. In Example 2, the CO₂ flow ratio was changed from that in Example 1 for the purpose of compensating for a change in optimum value of the SiH₄/CO₂ flow ratio due to change of the deposition pressure. In Example 2, the refractive index of the obtained n-type silicon composite layer 33 to light having a wavelength of 600 nm was also 2.0.

The stacked-type photoelectric conversion device of Example 2 had the following photoelectric conversion characteristics: Voc = 1.38 V, Isc = 11.27 mA/cm², F.F. = 0.723 and Eff. = 11.21 %.

### (Example 3)

In Example 3, the gas flow ratio was changed to SiH₄/H₂ = 1/150, and the power density was changed to 110.0 mW/cm² in deposition of the crystalline silicon photoelectric conversion layer 42 of the rear photoelectric conversion unit 4. Otherwise in the same manner as in Example 1, a double-junction-type stacked-type photoelectric conversion device was prepared. In Example 3, the SiH₄/ H₂ flow ratio was changed from that in Example 1 for the purpose of correcting a shift in crystallinity of the crystalline silicon photoelectric conversion layer due to reduction of the power density.

The stacked-type photoelectric conversion device of Example 3 had the following photoelectric conversion characteristics: Voc = 1.39 V, Isc = 11.12 mA/cm², F.F. = 0.728 and Eff. = 11.24 %.

### (Example 4)

In Example 4, the power density was changed to 70.0 mW/cm² and the SiH₄/H₂ flow ratio was changed to 1/250 for correcting a shift in crystallinity in deposition of the crystalline silicon photoelectric conversion layer 42 of the rear photoelectric conversion unit 4. Otherwise in the same manner as in Example 1, a double-junction-type stacked-type photoelectric conversion device was prepared. The stacked-type photoelectric conversion device of Example 4 had the following photoelectric conversion characteristics: Voc = 1.37 V, Isc = 11.62 mA/cm², F.F. = 0.720 and Eff. = 11.44 %.

### (Example 5)

In Example 5, an initial part 421 having a thickness of 0.5 µm was formed under the same deposition conditions as in Example 1 in deposition of the crystalline silicon photoelectric conversion layer 42 of the rear photoelectric conversion unit 4. Thereafter, the power density was changed to 208.3 and the gas flow ratio was changed to SiH₄/H₂ = 1/97 by decreasing the hydrogen gas flow rate without stopping plasma discharge and gas supply, so that a bulk part 422 of the crystalline silicon photoelectric conversion layer was formed in a thickness of 2.0 µm. Otherwise in the same manner as in Example 1, a double-junction-type stacked-type photoelectric conversion device was prepared. The stacked-type photoelectric conversion device of Example 4 had the following photoelectric conversion characteristics: Voc = 1.34 V, Isc = 11.37 mA/cm², F.F. = 0.718 and Eff. = 10.99 %.

### (Comparative Example 1)

In Comparative Example 1, the power density was changed to 163.7 mW/cm² and the gas flow ratio was changed to SiH₄/CO₂/PH₃/H₂ = 1/2.5/0.025/350, for the purpose of optimizing the SiH₄/CO₂ flow ratio in deposition of the n-type silicon composite layer 33. Otherwise in the same manner as in Example 1, a double-junction-type stacked-type photoelectric conversion device was prepared. In Comparative Example 1, the refractive index of the n-type silicon composite layer 33 to light having a wavelength of 600 nm was also 2.0. The stacked-type photoelectric conversion device of Comparative Example 1 had the following photoelectric conversion characteristics: Voc = 1.37 V, Isc = 11.03 mA/cm², F.F. = 0.725 and Eff. = 10.93 %.

### (Comparative Example 2)

In Comparative Example 2, the power density was changed to 208.3 mW/cm² and the gas flow ratio was changed to SiH₄/H₂ = 1/97 for correcting a shift in crystallinity in formation of the crystalline silicon photoelectric conversion layer 42 of the rear photoelectric conversion unit 4. Otherwise in the same manner as in Example 1, a double-junction-type stacked-type photoelectric conversion device was prepared. The stacked-type photoelectric conversion device of Comparative Example 2 had the following photoelectric conversion characteristics: Voc = 1.36 V, Isc = 11.14 mA/cm², F.F. = 0.729 and Eff. = 11.05 %.

### (Comparative Example 3)

In Comparative Example 3, the deposition pressure was changed to 1200 Pa and the SiH₄/H₂ flow ratio was changed to 1/108 for correcting a shift in crystallinity in deposition of the crystalline silicon photoelectric conversion layer 42 of the rear photoelectric conversion unit 4. Otherwise in the same manner as in Comparative Example 2, a double-junction-type stacked-type photoelectric conversion device was prepared. The stacked-type photoelectric conversion device of Comparative Example 3 had the following photoelectric conversion characteristics: Voc = 1.36 V, Isc = 11.35 mA/cm², F.F. = 0.726 and Eff. = 11.22 %.

### (Comparative Example 4)

In Comparative Example 4, the power density was changed to 167.3 mW/cm² and the SiH₄/H₂ flow ratio was changed to 1/105 for correcting a shift in crystallinity in deposition of the crystalline silicon photoelectric conversion layer 42 of the rear photoelectric conversion unit 4. Otherwise in the same manner as in Example 1, a double-junction-type stacked-type photoelectric conversion device was prepared. The stacked-type photoelectric conversion device of Comparative Example 4 had the following photoelectric conversion characteristics: Voc = 1.37 V, Isc = 11.39 mA/cm², F.F. = 0.720 and Eff. = 11.20 %.

### [Quantitative Determination of Impurities in Crystalline Photoelectric Conversion Layer]

A concentration of impurities (C, O and P) in the crystalline silicon photoelectric conversion layer of the stacked-type photoelectric conversion device in each of Examples and Comparative Examples described above was quantitatively determined by secondary ion mass spectroscopy (SIMS), and an average value in a film thickness range of from a film thickness at the initial stage of deposition to 500 nm was defined as an impurity amount. In Example 5, the deposition condition (power density) was different between the initial deposition part 421 and the bulk part 422 in the crystalline photoelectric conversion layer 42, but there was no evident difference in impurity amount between both the parts.

### [Heating and Humidification Durability Test]

The stacked-type photoelectric conversion device in each of Examples and Comparative Examples described above was exposed to a constant-temperature and constant-humidity environment at a temperature of 85°C and a humidity of 85% for 20 hours, photoelectric conversion characteristics were then measured using a solar simulator, and a change rate of conversion efficiency Eff₁ after the heating and humidification test to initial conversion efficiency Eff₀ before the test was calculated in accordance with the equation: change rate (performance degradation rate) (%) = (Eff₁ - Effo) × 100/Eff₀. A lower performance degradation rate shows better durability.

### [Evaluation Results]

Deposition conditions (power density and pressure) for the n-type silicon composite layer, deposition conditions (power density and pressure) for the crystalline silicon photoelectric conversion layer, initial conversion efficiency Effo, conversion efficiency Eff₁ after the heating and humidification durability test and the performance degradation rate associated with the heating and humidification durability test in each of Examples and Comparative Examples described above are shown in Table 1.

In Table 1, the "power density ratio" is a ratio of power densities during deposition of the silicon composite layer and during deposition of the crystalline photoelectric conversion layer of the rear photoelectric conversion unit, and shows a value obtained by dividing a power density during deposition of the photoelectric conversion layer of the rear photoelectric conversion unit by a power density during deposition of the silicon composite layer. The "pressure ratio" in Table 1 is a ratio of deposition pressures during deposition of the silicon composite layer and during deposition of the crystalline photoelectric conversion layer of the rear photoelectric conversion unit, and shows a value obtained by dividing a deposition pressure during deposition of the photoelectric conversion layer of the rear photoelectric conversion unit by a deposition pressure during deposition of the silicon composite layer. The power density ratio and pressure ratio being higher than 1 shows that the photoelectric conversion layer of the rear photoelectric conversion unit was formed with a higher power density and pressure as compared to the silicon composite layer.

**[Table 1]**

| | deposition conditions | | | | | | | conversion efficiency | | | |
|---|---|---|---|---|---|---|---|---|---|---|---|
| | Power density [mW/cm²] | | | power density ratio | pressure [Pa] | | pressure ratio | Eff₀ [%] | Eff₁[%] | performance degradation rate | |
| | Silicon composit e layer | crystalline photoelectric conversion layer | | | silicon composite layer | crystalline photoelectric conversion layer | | | | | |
| | | initial part | bulk part | | | | | | | absolute value (%) | relative value |
| Example 1 | 163.7 | 148.8 | | 0.91 | 990 | 990 | 1.00 | 11.18 | 11.08 | 0.9 | 0.08 |
| Example 2 | 163.7 | 148.8 | | 0.91 | 750 | 990 | 1.32 | 11.21 | 11.13 | 0.7 | 0.06 |
| Example 3 | 163.7 | 110.0 | | 0.67 | 990 | 990 | 1.00 | 11.24 | 11.19 | 0.5 | 0.04 |
| Example 4 | 163.7 | 70.0 | | 0.43 | 990 | 990 | 1.00 | 11.44 | 11.36 | 0.7 | 0.06 |
| Example 5 | 163.7 | 148.8 | 208.3 | 0.91 | 990 | 990 | 1.00 | 10.99 | 10.82 | 1.5 | 0.13 |
| Comparative Example 1 | 74.4 | 148.8 | | 2.00 | 990 | 990 | 1.00 | 10.93 | 9.70 | 11.3 | 1.00 |
| Comparative Example 2 | 163.7 | 208.3 | | 1.27 | 990 | 990 | 1.00 | 11.05 | 10.45 | 5.4 | 0.48 |
| Comparative Example 3 | 163.7 | 208.3 | | 1.27 | 990 | 1300 | 1.31 | 11.22 | 10.85 | 3.3 | 0.29 |
| Comparative Example 4 | 163.7 | 163.7 | | 1.00 | 990 | 990 | 1.00 | 11.20 | 11.01 | 1.7 | 0.15 |

As shown in Table 1, the stacked-type photoelectric conversion device in each Example has initial conversion efficiency Eff₀ equal to or more than that of the stacked-type photoelectric conversion device in Comparative Example, and retains a high value of conversion efficiency Eff₁ even after being exposed to a high-temperature and high-humidity environment.

When examining the performance degradation rate more closely, performance degradation after exposure to a high-temperature and high-humidity environment is significant in Comparative Example 1 in which the crystalline silicon photoelectric conversion layer was formed with a power density that is 2 times the power density for forming the silicon composite layer. Comparison of Comparative Examples 1, 2 and 4 and Examples 1 and 3 shows that the performance degradation rate after exposure to a high-temperature and high-humidity environment becomes smaller as the power density ratio decreased. Example 1 and Comparative Example 1 have the same deposition pressure for the crystalline photoelectric conversion layer, but in Example 1 having a low power density ratio, the performance degradation rate is small (durability is improved). From these results, it is apparent that durability is more significantly improved by ensuring that rather than a value of power density during deposition of the crystalline photoelectric conversion layer, a ratio of power densities during deposition of the silicon composite layer and during deposition of the crystalline photoelectric conversion layer falls within a predetermined range.

Example 4 has a power density ratio lower than that in Example 3, but has a comparable performance degradation rate. When considering productivity of the stacked-type photoelectric conversion device, a higher power density ratio is more preferable, and therefore the power density ratio may be especially preferably 0.5 or more for securing both productivity and durability.

In Example 5 where the silicon composite layer and the initial deposition part of the crystalline photoelectric conversion layer were formed with a power density identical to that in Example 1 and the bulk part of the crystalline photoelectric conversion layer was formed with a high power density comparable to that in Comparative Example 2, initial conversion efficiency Eff₀ was comparable to that in Comparative Example 2, but conversion efficiency Eff₁ after the heating and humidification test was higher than that in Comparative Example 2, so that excellent durability was achieved. From this result, it is apparent that by forming the initial deposition part of the crystalline photoelectric conversion layer with a low power density and forming the bulk part as the rest with an increased power density, productivity of the stacked-type photoelectric conversion device can be enhanced while high durability was maintained.

Comparison of Examples 1 and 2 and comparison of Comparative Examples 2 and 3 show that durability is improved by increasing a ratio of pressures during deposition of the silicon composite layer and during deposition of the crystalline photoelectric conversion layer. When collectively examining results in Examples and Comparative Examples, improvement of durability is more significantly affected by decreasing the power density ratio than by increasing the pressure ratio.

Concentrations of impurities in crystalline silicon photoelectric conversion layers in Examples and Comparative Examples are shown in Table 2 (not measured in Example 3). In addition to values of concentrations of atoms of carbon (C), oxygen (O) and phosphorus (P), Table 2 shows relative values of concentration compared with Comparative Example 1.

**[Table 2]**

| | impurity concentration [atm/cm³] | | | relative value | | |
|---|---|---|---|---|---|---|
| | C | O | P | C | O | P |
| Example 1 | 3.6×10¹⁶ | 1.4×10¹⁸ | 7.4×10¹⁶ | 0.03 | 0.39 | 0.45 |
| Example 2 | 4.2×10¹⁶ | 1.4×10¹⁸ | 5.8×10¹⁶ | 0.04 | 0.40 | 0.36 |
| Example 4 | 2.2×10¹⁶ | 8.8×10¹⁷ | 7.0×10¹⁶ | 0.02 | 0.25 | 0.44 |
| Example 5 | 5.5×10¹⁶ | 1.8×10¹⁸ | 9.1×10¹⁶ | 0.05 | 0.52 | 0.55 |
| Comparative Example 1 | 1.1×10¹⁸ | 3.5×10¹⁸ | 1.6×10¹⁷ | 1 | 1 | 1 |
| Comparative Example 2 | 2.1×10¹⁷ | 3.4×10¹⁸ | 1.1×10¹⁷ | 0.19 | 0.96 | 0.65 |
| Comparative Example 3 | 1.2×10¹⁷ | 1.7×10¹⁸ | 9.9×10¹⁶ | 0.11 | 0.49 | 0.60 |
| Comparative Example 4 | 7.3×10¹⁶ | 2.3×10¹⁸ | 6.8×10¹⁶ | 0.07 | 0.66 | 0.41 |

According to Table 2, in Examples, the concentration of impurities (particularly carbon atom concentration and oxygen atom concentration) in the crystalline photoelectric conversion layer is low and there is a high correlation between the impurity concentration and performance degradation rate as compared to Comparative Examples. It is considered from these results that in the present invention, predetermined deposition conditions are employed to suppress ingress of impurities in the silicon composite layer into the rear photoelectric conversion unit, resulting in improvement of durability.

### DESCRIPTION OF REFERENCE CHARACTERS

- 1: Transparent insulating substrate
- 2: Transparent electrode layer
- 3: Front photoelectric conversion unit (Amorphous photoelectric conversion unit)
- 31: One-conductivity-type layer (p-type silicon-based layer)
- 32: Photoelectric conversion layer (i-type amorphous silicon-based photoelectric conversion layer)
- 33: Reverse-conductivity-type layer (n-type layer including silicon composite layer)
- 4.: Rear photoelectric conversion unit (crystalline photoelectric conversion unit)
- 41: One-conductivity-type layer (p-type crystalline silicon-based layer)
- 42: Photoelectric conversion layer (i-type crystalline silicon-based photoelectric conversion layer)
- 421: initial deposition part
- 422: bulk part
- 43: Reverse-conductivity-type layer (n-type silicon-based layer)
- 5: Back electrode

## Claims

1. A method for manufacturing a stacked-type photoelectric conversion device, the stacked-type photoelectric conversion device comprising at least a front photoelectric conversion unit and a rear photoelectric conversion unit from the light incident side,
the method comprising the steps of: forming a front photoelectric conversion unit by a plasma-enhanced CVD method; and forming a rear photoelectric conversion unit on the front photoelectric conversion unit by a plasma-enhanced method,
wherein in the front photoelectric conversion unit forming step, a one-conductivity-type layer, a substantially intrinsic amorphous silicon-based photoelectric conversion layer and a reverse-conductivity-type layer are formed in this order, and the reverse-conductivity-type layer of the front photoelectric conversion unit is a silicon composite layer at least on a side in contact with the rear photoelectric conversion unit, the silicon composite layer including a silicon crystalline phase in an amorphous alloy containing silicon and oxygen;
in the rear photoelectric conversion unit forming step, a crystalline one-conductivity-type layer, a substantially intrinsic crystalline silicon-based photoelectric conversion layer and a reverse-conductivity-type layer are formed in this order;
after the silicon composite layer is formed, the crystalline one-conductivity-type layer and the crystalline silicon-based photoelectric conversion layer of the rear photoelectric conversion unit are sequentially formed in the same deposition chamber without being taken out into the ambient air; and
the crystalline silicon-based photoelectric conversion layer of the rear photoelectric conversion unit has a carbon concentration of 1 × 10¹⁷ atm/cm³ or less, and an oxygen concentration of 2 × 10¹⁸ atm/cm³.

2. The method for manufacturing a stacked-type photoelectric conversion device according to claim 1, wherein a power density at the start of deposition of the crystalline silicon-based photoelectric conversion layer of the rear photoelectric conversion unit is not less than 0.1 times and less than 1 times of a power density during deposition of the silicon composite layer of the front photoelectric conversion unit.

3. The method for manufacturing a stacked-type photoelectric conversion device according to claim 1 or 2, wherein a deposition pressure at the start of deposition of the crystalline silicon-based photoelectric conversion layer of the rear photoelectric conversion unit is higher than a deposition pressure during deposition of the silicon composite layer of the front photoelectric conversion unit.

4. The method for manufacturing a stacked-type photoelectric conversion device according to any one of claims 1 to 3, wherein the crystalline silicon-based photoelectric conversion layer of the rear photoelectric conversion unit is formed by depositing an initial deposition part with a power density that is not less than 0.1 times and less than 1 times of the power density during deposition of the silicon composite layer of the front photoelectric conversion unit, followed by forming a bulk part as the rest with a power density higher than that for the initial deposition part.

5. The method for manufacturing a stacked-type photoelectric conversion device according to claim 4, wherein the power density during deposition of the bulk part of the crystalline silicon-based photoelectric conversion layer of the rear photoelectric conversion unit is not less than the power density during deposition of the silicon composite layer of the front photoelectric conversion unit.

6. A method for manufacturing a stacked-type photoelectric conversion device, the stacked-type photoelectric conversion device comprising at least a front photoelectric conversion unit and a rear photoelectric conversion unit from the light incident side,
the method comprising the steps of: forming a front photoelectric conversion unit by a plasma-enhanced CVD method; and forming a rear photoelectric conversion unit on the front photoelectric conversion unit by a plasma-enhanced method,
wherein in the front photoelectric conversion unit forming step, a one-conductivity-type layer, a substantially intrinsic amorphous silicon-based photoelectric conversion layer and a reverse-conductivity-type layer are formed in this order, and the reverse-conductivity-type layer of the front photoelectric conversion unit is a silicon composite layer at least on a side in contact with the rear photoelectric conversion unit, the silicon composite layer including a silicon crystalline phase in an amorphous alloy containing silicon and oxygen;
in the rear photoelectric conversion unit forming step, a crystalline one-conductivity-type layer, a substantially intrinsic crystalline silicon-based photoelectric conversion layer and a reverse-conductivity-type layer are formed in this order;
after the silicon composite layer is formed, the crystalline one-conductivity-type layer and the crystalline silicon-based photoelectric conversion layer of the rear photoelectric conversion unit are sequentially formed in the same deposition chamber without being taken out into the ambient air; and
a power density at the start of deposition of the crystalline silicon-based photoelectric conversion layer of the rear photoelectric conversion unit is not less than 0.1 times and less than 1 times of a power density during deposition of the silicon composite layer of the front photoelectric conversion unit.

7. The method for manufacturing a stacked-type photoelectric conversion device according to claim 6, wherein a deposition pressure at the start of deposition of the crystalline silicon-based photoelectric conversion layer of the rear photoelectric conversion unit is higher than a deposition pressure during deposition of the silicon composite layer of the front photoelectric conversion unit.

8. The method for manufacturing a stacked-type photoelectric conversion device according to claim 6 or 7, wherein the crystalline silicon-based photoelectric conversion layer of the rear photoelectric conversion unit is formed by depositing an initial deposition part with a power density that is not less than 0.1 times and less than 1 times of the power density during deposition of the silicon composite layer of the front photoelectric conversion unit, followed by forming a bulk part as the rest with a power density higher than that for the initial deposition part.

9. The method for manufacturing a stacked-type photoelectric conversion device according to claim 8, wherein the power density during deposition of the bulk part of the crystalline silicon-based photoelectric conversion layer of the rear photoelectric conversion unit is not less than the power density during deposition of the silicon composite layer of the front photoelectric conversion unit.
